# FASCICULE DE BREVET EUROPEEN

(11) **EP 1 683 157 B1**
(45) Date de publication et mention de la délivrance du brevet: **11.07.2007**
(21) Numéro de dépôt: 04805797.0
(22) Date de dépôt: 02.11.2004
(51) Int. Cl.: G11C 13/00

(54) **ELEMENT DE MEMOIRE A CHANGEMENT DE PHASE A CYCLABILITE AMELIOREE**
PHASENÄNDERUNGS-SPEICHERELEMENT MIT VERBESSERTER ZYKLIERBARKEIT
PHASE CHANGE MEMORY ELEMENT WITH IMPROVED CYCLABILITY

(30) Priorité: 04.11.2003 FR 0350784
(43) Date de publication de la demande: 26.07.2006
(73) Titulaire: COMMISSARIAT A L'ENERGIE ATOMIQUE, 75015 Paris (FR)
(72) Inventeur: SOUSA, Véronique, F-38000 Grenoble (FR); DESRE, Pierre, F-38240 Meylan (FR)
(74) Mandataire: Poulin, Gérard
(86) Numéro de dépôt international: PCT/FR2004/050554
(87) Numéro de publication internationale: WO 2005/045847

(56) Documents cités:
- US-A- 4 115 872
- US-A- 4 177 475
- US-A- 5 363 329

## Description

### DOMAINE TECHNIQUE

La présente invention est relative à un élément de mémoire à changement de phase apte à subir un grand nombre de cycles d'écriture. Cette aptitude est qualifiée de « cyclabilité ». Un tel élément de mémoire est réalisé à base de matériaux mémoire à changement de phase (c'est à dire apte à passer d'une phase amorphe à une phase cristalline et vice versa) et s'applique aux mémoires connues sous la dénomination anglo-saxonne de PC-RAM soit Phase-Change Random Access Memory soit mémoire vive à changement de phase.

### ÉTAT DE LA TECHNIQUE ANTERIEURE

Il existe de nombreux types de mémoires et leur emploi est fonction des applications et des performances visées. Lorsque des temps d'écriture ultra-rapides sont requis, on fait appel aux mémoires SRAM (abréviation de static random access memory ou mémoire vive statique) constituées par l'agencement de plusieurs transistors. Les principaux inconvénients de ces mémoires sont qu'elles sont volatiles (c'est à dire dont le contenu est perdu lorsque l'alimentation électrique est coupée) et que la taille de l'élément de mémoire est relativement grande, ce qui ne permet pas une grande capacité de stockage sur une surface réduite. Pour une plus grande capacité de stockage, on utilise les mémoires DRAM (abréviation de dymamic random acces memory pour mémoire vive dymamique) dans lesquelles les charges électriques sont stockées sur une capacité. Ces mémoires sont également volatiles, le temps de rétention de l'information étant de l'ordre de quelques dizaines de microsecondes.

Pour des applications qui nécessitent un stockage de l'information même lorsque l'alimentation électrique est coupée, on utilise des mémoires EEPROM ou FLASH. Le principe de ces mémoires repose sur le stockage de charges électriques sur la grille flottante de transistors à effet de champ. Chaque élément de mémoire est constitué d'un ou plusieurs composants semi-conducteurs. La tendance actuelle est de réduire la taille de ces composants, ce qui engendre une diminution du signal de lecture et une diminution de la durée de rétention de l'information. En conséquence, la densité de ce type de mémoire est limitée. De plus, ces mémoires présentent des temps d'écriture relativement longs, par exemple de l'ordre de la milliseconde, car c'est le temps nécessaire pour que les électrons passent sous la grille flottante par effet tunnel. Ces mémoires présentent aussi un nombre de cycles d'écriture limité (de l'ordre de 10⁶). En effet la rétention d'informations diminue au fur et à mesure des cycles d'écriture à cause du fait qu'il se crée des défauts dans la couche d'oxyde de grille ce qui permet aux électrons de s'échapper de la grille flottante.

De nouveaux concepts de mémoires non volatiles, réinscriptibles sont en développement. Ces mémoires utilisent des matériaux mémoire tels que des matériaux ferro-électriques (mémoires FERAM), des matériaux magnétiques (mémoires MRAM), des matériaux à changement de phase tels que des chalcogénures notamment à base de tellure qui peuvent passer d'une phase amorphe à une phase cristalline et vice versa (mémoires PC-RAM).

Le principe de fonctionnement des mémoires PC-RAM repose donc sur la transition amorphe-cristal d'un matériau à changement de phase placé en sandwich entre deux contacts électriques. Chacun de ces contacts appartient généralement à un conducteur, et le matériau à changement de phase se trouve à la croisée entre deux conducteurs qui sont sensiblement perpendiculaires. Une mémoire comporte plusieurs éléments de mémoire ainsi formés.

Dans ce type de mémoire, le signal de lecture résulte de la différence de résistivité électrique entre les deux phases.

L'écriture se fait de manière thermique et électrique. L'application d'une impulsion électrique d'écriture de quelques nanosecondes entre les deux contacts électriques provoque, par effet Joule, la fusion du matériau à changement de phase initialement cristallin. L'arrêt de l'impulsion provoque une trempe rapide qui conduit à la phase amorphe du matériau à changement de phase (état fortement résistant ou non-conducteur). Le retour à l'état initial se fait en appliquant entre les deux contacts une impulsion de plus faible intensité et de durée de l'ordre de la dizaine de nanosecondes. Cette impulsion provoque la cristallisation du matériau à changement de phase (état faiblement résistant ou conducteur).

Un avantage de ces mémoires de type PC-RAM est que leur temps d'écriture est très petit (de l'ordre de quelques nano-secondes) et bien plus petit que celui des mémoires EEPROM (de l'ordre de quelques millisecondes). Un autre attrait de ces mémoires PC-RAM est leur grande cyclabilité (de l'ordre de 10¹²) et bien plus grande que celle des mémoires de type EEPROM (de l'ordre de 10⁶). Ces mémoires vieillissent bien.

On cherche à augmenter encore la cyclabilité des mémoires de type PC-RAM au-delà de 10¹⁴ et donc à améliorer aussi leur durée de vie de manière à ce qu'elles puissent concurrencer les mémoires de type DRAM qui ont comme défauts d'être volatiles.

Lorsqu'un élément de mémoire à changement de phase arrive en fin de vie, on note d'abord une instabilité de la valeur de la résistivité du matériau à changement de phase, lorsqu'il est dans sa phase amorphe, ce qui affecte les opérations d'écriture, puis une impossibilité de cristallisation du matériau ce qui rend impossible un retour à l'état initial.

Les brevets américains dont les numéros suivent illustrent des exemples de mémoires de type PC-RAM : US-4 177 475, US-5 363 329, US 5-414 271. Ces documents préconisent d'insérer entre les deux contacts électriques, des régions de matériau à changement de phase de composition graduelle ou multicouche dans le but de réduire des phénomènes d'électromigration entre contact électrique et matériau à changement de phase, ce qui permet de diminuer la dérive de la résistivité au cours du temps.

Dans le brevet US 4 177 475 sur lequel le préambule de la revendication 1 se fonde, entre les deux contacts électriques se trouve un empilement de trois couches, réalisées à base de germanium et de tellure, mais toutes de compositions différentes. La couche centrale est active, c'est elle qui va fondre et passer de l'état amorphe à l'état cristallin et vice versa. Les couches extrêmes de l'empilement servent à pallier, au cours des cycles, l'évolution du seuil de tension assurant la transition entre l'état fortement résistant et l'état conducteur.

Ces structures qui visent à augmenter la cyclabilité ne permettent pas de délimiter et de stabiliser la quantité de matériau fondu et rendu amorphe au cours des cycles. Il s'en suit des variations de l'étendue de la zone fondue et des difficultés de reproductibilité de la valeur de la résistance au cours des cycles d'écriture d'un même élément de mémoire ou bien au cours d'un même cycle d'écriture d'un élément de mémoire à un autre.

La figure 4A du brevet US-4 177 475 illustre le fait que, compte tenu des compositions différentes de la couche centrale et des deux couches extrêmes, il se produit une interdiffusion des composants des couches extrêmes et de la couche centrale. Même si les couches extrêmes ne changent pas ou pas totalement d'état lors d'une opération d'écriture, elles ne sont pas pour autant passives, leur interface avec la couche centrale n'est pas inerte d'un point de vue physico-chimique. Plus le nombre de cycles d'écriture augmente plus la composition de l'empilement tend vers une composition unique voisine de celle de l'eutectique qui est aussi celle de la couche centrale initialement.

### EXPOSÉ DE L'INVENTION

La présente invention a pour but de proposer un élément de mémoire de type à changement de phase à cyclabilité et vieillissement améliorés, mais ne présentant pas les limitations et difficultés évoquées ci-dessus.

Plus précisément, un but de l'invention est de proposer un élément de mémoire à changement de phase dans lequel la quantité du matériau mémoire à changement de phase qui fond et devient amorphe est délimitée et stabilisée sous l'effet des impulsions d'écriture.

Un autre but de l'invention est de proposer un élément de mémoire à changement de phase dont la valeur de la résistance du matériau mémoire à changement de phase reste sensiblement constante au cours du temps ou reste sensiblement constante par rapport à celle d'un élément de mémoire voisin lorsque plusieurs éléments de mémoire sont associés dans une mémoire.

Encore un autre but de l'invention est d'obtenir un confinement latéral de la quantité de matériau mémoire à changement de phase fondu sous l'effet des impulsions d'écriture.

Encore un autre but de l'invention est de proposer un élément de mémoire à changement de phase à sensibilité améliorée aux impulsions d'écriture et à consommation d'énergie réduite.

Encore un autre but de l'invention est de proposer un élément de mémoire à changement de phase pour lequel le signal de lecture ne se dégradera pas ou quasiment pas dans le temps.

Enfin un autre but de l'invention est de proposer un élément de mémoire à changement de phase à vitesse d'écriture accrue.

La présente invention est un élément de mémoire à changement de phase comme défini par la revendication 1. Elle comporte entre deux contacts électriques une partie en matériau mémoire à changement de phase amorphe-cristal et vice versa, en forme d'empilement, avec une zone centrale située entre deux zones extrêmes. Selon l'invention, une interface inerte ou quasi inerte d'un point de vue physico-chimique est présente entre la zone centrale dite active et chaque zone extrême dite passive, chaque zone extrême passive étant réalisée dans un matériau possédant une température de fusion supérieure à celle du matériau de la zone centrale active.

Par équilibre ou quasi équilibre physico-chimique entre deux phases, on entend l'équilibre qui est réalisé à une température donnée, lorsque le potentiel chimique de chaque constituant a la même valeur dans les deux phases en coexistence. Cet équilibre est physico-chimique car résultant d'une transformation physique entre les deux phases.

Ainsi, avec cet empilement à interface inerte ou quasi inerte la quantité de matériau fondu lors d'une opération d'écriture est délimitée et stabilisée.

En vue d'améliorer la sensibilité de l'élément de mémoire lors de l'écriture et de réduire sa consommation d'énergie, chaque zone extrême passive est réalisée, de préférence, dans un matériau possédant une conductivité thermique inférieure ou égale à celle du matériau du contact électrique qui lui est le plus proche et/ou à celle du matériau de la zone centrale active.

De manière à éviter une dégradation du signal de lecture, les zones extrêmes passives peuvent avoir, dans une phase cristalline, une résistance électrique inférieure ou égale à celle de la zone centrale active lorsqu'elle est dans une phase cristalline.

En vue d'obtenir une vitesse d'écriture accrue, chaque zone extrême passive peut être réalisée dans un matériau favorisant un phénomène de formation de germes cristallins dans la zone centrale active à proximité de l'interface.

Il est possible que chaque zone extrême passive soit réalisée dans un matériau sensiblement de même nature chimique, mais de composition différente, que celles du matériau de la zone centrale active.

Le matériau de la zone centrale active peut comporter entre environ 16% et 30% de tellure et entre environ 84% et 70% d'antimoine, le matériau de chaque zone extrême passive étant de l'antimoine éventuellement mélangé à du tellure avec un pourcentage allant jusqu'à environ 2%, ces pourcentages étant des pourcentages atomiques.

Dans un autre mode de réalisation, chaque zone extrême passive peut être réalisée dans un matériau qui est de nature chimique différente de celle du matériau de la zone centrale active, ce matériau ayant une solubilité très faible dans le matériau de la zone centrale active.

Le matériau de la zone centrale active peut être du Ge2Sb2Te5 et le matériau de chaque zone extrême passive du GeN.

Dans un but de simplification, les zones extrêmes passives peuvent être réalisées dans un même matériau.

Pour améliorer encore la stabilisation et la délimitation de la zone fondue, la zone centrale active peut être confinée au moins partiellement latéralement par du matériau électriquement isolant.

Au moins une des zones extrêmes passives peut déborder latéralement de la zone centrale active, le choix se faisant en fonction de la conductivité thermique du matériau qui la compose. Dans un autre mode de réalisation, au moins une des zones extrêmes passives et la zone centrale active coïncident latéralement.

Il est également possible qu'au moins une des zones extrêmes passives soit bordée par du matériau électriquement isolant.

La présente invention concerne aussi une mémoire à changement de phase qui comporte une pluralité d'éléments de mémoire ainsi définis.

La présente invention concerne également un procédé de fabrication d'au moins un élément de mémoire à changement de phase comportant, entre un premier et un second contacts électriques, une partie en matériau mémoire à changement de phase amorphe-cristal et vice versa, avec une zone centrale située entre une première et une seconde zones extrêmes. Le procédé comporte les étapes suivantes :
a) réalisation d'un premier contact électrique sur un substrat,
b) réalisation sur le premier contact électrique de la première zone extrême dite passive, de la zone centrale dite active et de la seconde zone extrême dite passive, ces zones formant un empilement possédant une interface, inerte ou quasi inerte d'un point de vue physico-chimique, entre chaque zone extrême passive et la zone centrale active qui est plus fusible que les zones extrêmes passives,
c) réalisation d'un confinement latéral au moins partiel d'au moins la zone centrale active avec un matériau électriquement isolant,
d) réalisation du second contact électrique sur l'empilement.

Les étapes b) et c) peuvent comprendre, après avoir réalisé la première zone extrême passive, les opérations suivantes :
- dépôt du matériau électriquement isolant conduisant au confinement latéral, sur la première zone extrême passive,
- creusement d'un puits dans le matériau électriquement isolant ayant un fond qui atteint la première zone extrême passive,
- remplissage du puits avec une couche conduisant à la zone centrale active,
- réalisation de la seconde zone extrême passive au-dessus du puits.

En variante, les étapes b) et c) peuvent comprendre les opérations suivantes :
- dépôt sur le premier contact électrique d'une première couche conduisant à la première zone extrême passive,
- dépôt sur la première couche d'une seconde couche conduisant à la zone centrale active,
- dépôt sur la seconde couche d'une troisième couche conduisant à la seconde zone extrême passive,
- délimitation en colonne des trois couches déposées pour former l'empilement,
- enrobage latéral de l'empilement avec un matériau électriquement isolant de confinement, ce matériau conduisant au confinement.

Dans un autre mode de réalisation, les étapes b) et c) peuvent comporter les opérations suivantes :
- dépôt sur la première zone extrême passive d'une couche conduisant à la zone centrale active,
- délimitation de la zone centrale active,
- enrobage latéral de la zone centrale active avec un matériau électriquement isolant, ce matériau conduisant au confinement,
- réalisation de la seconde zone extrême passive sur la zone centrale active.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
les figures 1A et 1B sont des coupes d'éléments de mémoire selon l'invention ;
la figure 2 illustre un diagramme de phase du SbTe permettant d'expliquer le choix des matériaux de la partie à changement de phase d'un élément de mémoire selon l'invention ;
les figures 3A, 3B sont des coupes d'un élément de mémoire de l'art antérieur et d'un élément de mémoire selon l'invention sur lesquelles la zone fondue est matérialisée ;
les figures 4A à 4F illustrent un premier exemple de procédé de réalisation d'au moins un élément de mémoire selon l'invention ;
les figures 5A à 5F illustrent encore un autre exemple de procédé de réalisation d'éléments de mémoire selon l'invention ;
les figures 6A à 6C illustrent certaines étapes d'une variante d'un procédé de réalisation d'éléments de mémoire selon l'invention ;
les figures 7A à 7C illustrent certaines étapes d'une autre variante d'un procédé de réalisation d'éléments de mémoire selon l'invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

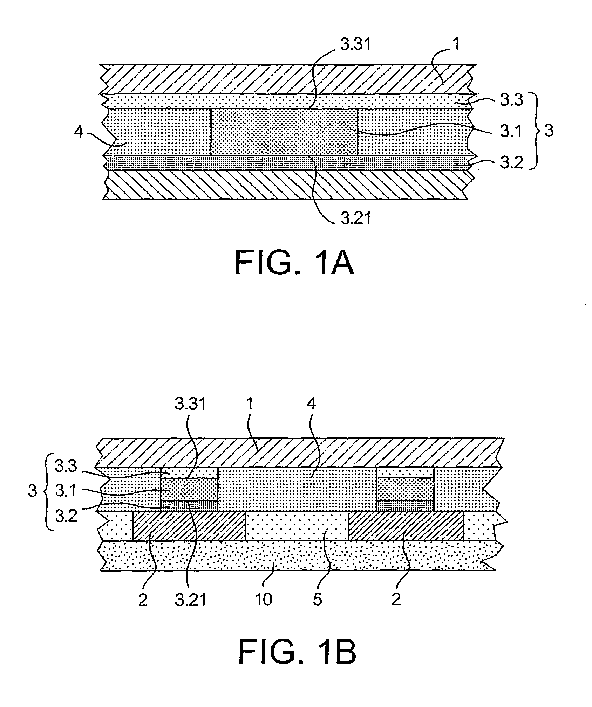

On va maintenant se référer à l'élément de mémoire à changement de phase conforme à l'invention tel que représenté sur la figure 1A ou sur la figure 1B. Cet élément de mémoire comporte deux contacts électriques 1, 2 espacés dont un est destiné à être porté à un potentiel plus positif que l'autre. Les deux contacts espacés 1, 2 sont séparés par une partie 3 en matériau mémoire à changement de phase de la famille des chalcogénures. Les contacts électriques 1, 2 sont destinés à être portés à des potentiels différents lors des cycles d'écriture de l'élément de mémoire. La partie 3 en matériau mémoire à changement de phase prend la forme d'un empilement avec une zone centrale 3.1 dite active prise en sandwich entre deux zones extrêmes 3.2, 3.3 dites passives. Il existe entre la zone centrale 3.1 et chacune des zones extrêmes 3.2, 3.3 une interface référencée 3.21 et 3.31 respectivement. Selon l'invention, ces interfaces 3.21, 3.31 sont inertes ou quasi inertes d'un point de vue physico-chimique. La définition de l'interface inerte ou quasi inerte d'un point de vue physico-chimique a été explicitée précédemment.

La zone centrale active 3.1 est ainsi en contact direct avec chacune des zones extrêmes passives 3.2, 3.3. Cette structure est très simple. L'interface 3.21, 3.31 entre la zone centrale active 3.1 et chacune des zones extrêmes passives est la limite commune aux zones active et passive. Cette interface étant inerte ou quasi inerte il n'y a pas ou quasiment pas de mélange entre zone active et zone passive.

La zone centrale active 3.1 peut être confinée latéralement par une zone électriquement isolante 4. La zone centrale active 3.1 peut prendre la forme d'un plot borné latéralement par la zone électriquement isolante 4 par exemple en oxyde ou en nitrure d'un matériau semi-conducteur (par exemple oxyde ou nitrure de silicium) et borné à ses deux extrémités par les zones extrêmes actives 3.2, 3.3. Ce bornage latéral contribue à la bonne reproductibilité du volume de matériau mémoire fondu lors d'un cycle d'écriture.

Le plot peut avoir un diamètre inférieur à 1 micromètre et de préférence inférieur à un dixième de micromètre. L'épaisseur des contacts électriques 1, 2 peut être comprise entre 50 et 200 10⁻⁹ mètre, l'épaisseur de la zone centrale active ainsi que l'épaisseur des zones extrêmes passives peuvent être comprises 20 et 200 10⁻⁹ mètre.

Dans l'exemple représenté sur la figure 1A, les zones extrêmes passives 3.2, 3.3 s'étendent latéralement au-delà de la zone centrale active 3.1. Elles prennent aussi en sandwich la zone électriquement isolante 4.

Dans une variante représentée à la figure 1B, la zone électriquement isolante 4 confine latéralement toute la partie 3 en matériau mémoire à changement de phase et pas seulement sa zone centrale active 3.1. Les zones extrêmes passives 3.2, 3.3 sont aussi bornées latéralement par la zone électriquement isolante 4. Le choix d'une structure plutôt qu'une autre dépend de la nature du matériau des zones extrêmes passives et de la facilité de réalisation technologique.

Une autre différence entre la figure 1A et la figure 1B est que sur la figure 1B sont représentés deux éléments de mémoire voisins d'une mémoire selon l'invention. Ces deux éléments de mémoire ont un contact électrique 1 commun (dans l'exemple le contact supérieur) alors que leur autre contact électrique 2 (le contact inférieur) leur est propre. Une telle mémoire comporte plusieurs éléments mémoire arrangés en réseau matriciel. Ainsi, dans cet exemple, les deux éléments de mémoire sont placés sur une même ligne du réseau matriciel mais pas sur une même colonne du réseau matriciel. Ces éléments mémoire sont regroupés sur un même substrat 10 de nature appropriée. Les contacts inférieurs 2 propres à chacun de éléments de mémoire sont séparés les uns des autres par du matériau électriquement isolant 5.

Chaque zone extrême passive peut être réalisée dans un matériau qui est sensiblement de même nature chimique mais de composition différente que celles du matériau de la zone centrale active.

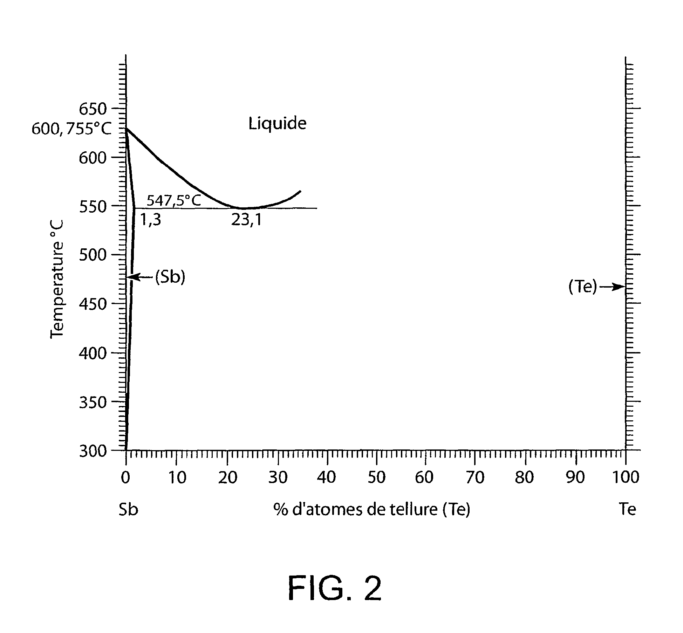

Le choix des matériaux pour la partie en matériau mémoire à changement de phase se fait de préférence à l'aide d'un diagramme de phases présentant un eutectique tel que celui illustré sur la figure 2. Ce diagramme permet de repérer les compositions en équilibre ou en quasi équilibre physico-chimique et qui conduisent donc aux interfaces inertes ou quasi inertes. Il est préférable dans un but de simplification que les deux zones extrêmes passives soient réalisées dans un même matériau, bien sûr ce n'est pas une obligation d'autres choix sont possibles.

Le matériau mémoire de la zone centrale active peut comporter entre environ 16% et 30% de tellure (Te) et entre environ 84% et 70% d'antimoine (Sb), sa température de fusion est comprise entre environ 550°C et 570°C. Le matériau mémoire des zones extrêmes passives doit avoir une température de fusion supérieure à celle du matériau actif et par exemple peut être de l'antimoine éventuellement mélangé à du tellure jusqu'à environ 2%. Sa température de fusion est comprise entre 628°C et 631°C.

En se référant au diagramme de phase du Sb-Te présenté sur la figure 2, on s'aperçoit que l'équilibre ou le quasi équilibre physico-chimique peut être obtenu avec comme matériau de la zone centrale active environ 23,1% d'antimoine et 76,9% de tellure dont la température de fusion est 547, 5°C et avec comme matériau des couches extrêmes passives un mélange antimoine tellure à 1,3% de tellure. La température de fusion de la composition eutectique de ce mélange antimoine tellure est de 630,75°C.

En variante, chaque zone extrême passive peut être réalisée dans un matériau qui est de nature chimique différente de celle du matériau de la zone centrale active, ce matériau ayant un produit de solubilité très faible dans le matériau de la zone centrale active.

Pour illustrer cette variante, le matériau mémoire de la couche centrale active est du Ge2Sb2Te5 dont la température de fusion est d'environ 600°c et le matériau mémoire des zones extrêmes passives est GeN.

Les proportions indiquées précédemment sont des pourcentage d'atomes.

En fait, pour déterminer le matériau constitutif de la couche active, l'homme du métier fait une sélection dans les matériaux connus pour réaliser les mémoires à changement de phase par exemple, tellure, germanium et antimoine. Pour que ce matériau ait une fusibilité maximale, sa composition est choisie voisine de l'eutectique à l'exception du germanium. Dans le cas d'un système plus complexe, c'est-à-dire comprenant plus de deux constituants, on prend comme matériau, pour la couche active, un matériau fusible et pour la couche passive, un matériau plus réfractaire, peu soluble dans la couche active et en équilibre physico-chimique. L'homme du métier procède par essais successifs pour choisir la composition des couches.

La couche passive peut être une céramique électriquement conductrice, par exemple un nitrure métallique, un carbure métallique.

Les contacts électriques peuvent être réalisés à base de cuivre, d'or, d'argent, de molybdène par exemple.

Des études générales sur les matériaux à changement de phase ont établi que les transitions de phase amorphe à phase cristal et vice versa étaient des transitions polymorphes, c'est à dire sans changement de composition.

Dans le processus de fusion suivi de l'amorphisation par hyper-trempe, un unique matériau mémoire à changement de phase se comporte comme un constituant pur. Au cours de la fusion du matériau mémoire à changement de phase soumis à une impulsion électrique appropriée, il se produit un déplacement rapide d'une interface liquide-solide et la vitesse de l'interface est contrôlée par le flux de chaleur produit par effet Joule. Cette vitesse est de l'ordre de plusieurs dizaines de mètres par seconde. Le retard à la fusion après l'application de l'impulsion électrique est extrêmement faible en comparaison du taux de surfusion du liquide obtenu pendant l'étape de trempe conduisant au matériau amorphe.

Dans le cas des éléments de mémoire à changement de phase de l'art antérieur, les transitions sont toujours polymorphes car elles résultent de la vitesse extrême de montée en température lors de l'application d'une impulsion visant à fondre la zone en matériau mémoire. La fusion du matériau mémoire à changement de phase est congruente, c'est à dire sans changement de composition lors du passage de la phase solide à la phase liquide. Si la fusion du matériau à changement de phase n'était pas congruente la diffusion imposée par le diagramme de phases et conduisant à une ségrégation ne pourrait s'accomplir.

Une vitesse élevée de déplacement de l'interface au cours de la fusion est défavorable à la reproductibilité, au cours des cycles d'écriture de la quantité de matériau mémoire à changement de phase fondu et ce qui est équivalent de la quantité de matériau mémoire à changement de phase rendu amorphe. Cette quantité varie de manière significative en réponse aux variations de la puissance électrique injectée. Ainsi donc la résistance électrique de la zone en matériau mémoire à changement de phase varie.

Selon l'invention, avec l'empilement formé de la zone centrale active et des deux zones extrêmes passives, on délimite et on stabilise la quantité de matériau mémoire à changement de phase fondu. On la cantonne à sensiblement la zone centrale car évidemment on ne peut empêcher la fusion congruente du matériau mémoire à changement de phase. La reproductibilité de la quantité de matériau fondu est obtenue avec cet empilement tricouche.

Le matériau mémoire des zones extrêmes peut être de même nature chimique que celui de la zone centrale mais de composition différente (voir premier exemple donné précédemment). Ce matériau est en équilibre ou en quasi équilibre avec le matériau de la zone centrale passive. Sa température de fusion est supérieure à celle du matériau de la zone centrale active, c'est-à-dire qu'il est plus réfractaire que le matériau de la zone centrale active. Le matériau mémoire des zones extrêmes restera totalement ou quasi totalement cristallin au cours des cycles d'écriture. Il ne fondra pas ou pratiquement pas.

Dans l'autre mode de réalisation, le matériau de chaque zone extrême passive est de nature différente de celle du matériau de la zone centrale active. Il aura une solubilité très faible dans le matériau de la zone centrale active. La température de fusion du matériau des zones extrêmes passives est toujours supérieure à celle du matériau de la zone centrale active, autrement dit il est plus réfractaire que le matériau de la zone centrale active. Le matériau mémoire des zones extrêmes restera totalement ou quasi totalement cristallin aux cours des cycles d'écriture. Il ne fondra pas ou pratiquement pas.

Si de manière exceptionnelle et par exemple accidentelle, due à la défaillance de réalisation de l'élément de mémoire, qui génère une surpuissance sur les contacts électriques entraînant, par augmentation de la température de l'interface une fusion partielle d'au moins une zone extrême passive de la partie en matériau mémoire à changement de phase, les inventeurs se sont aperçus qu'au cours de la fusion, l'interface inter-zone se déplace extrêmement peu. Dans le cas d'un excès de puissance crête, celle-ci ne peut se déplacer que par diffusion d'un des constituants dans la zone fondue. La vitesse de l'interface n'est alors seulement que de quelques mètres par seconde, vitesse beaucoup plus faible que celle d'une transformation polymorphe qui est de l'ordre de quelques dizaines de mètres par seconde. Le contrôle par diffusion en cas de surpuissance stabilise, lors de l'étape de fusion, la position de l'interface entre la zone centrale active et chacune des zones extrêmes passives et donc le contraste de résistivité. On assure ainsi la reproductibilité de la résistance.

Pour que cet effet stabilisant soit optimal, on cherche à ce que l'impulsion de lecture ait une puissance suffisante pour fondre la totalité du matériau de la zone centrale active. Si ce n'est pas le cas, on risque d'engendrer une fluctuation de contraste en résistance car les fluctuations de zone fondue couvrent des petites quantités de matériau à changement de phase à l'interface entre la zone centrale active et chacune des zones extrêmes passives. Il est même préférable de disposer d'une puissance légèrement excédentaire, ce qui ne menace pas la constance de la quantité fondue et donc rendue amorphe en raison de la stabilité positionnelle de l'interface entre la zone centrale active et chacune des zones extrêmes passives comme exposé précédemment.

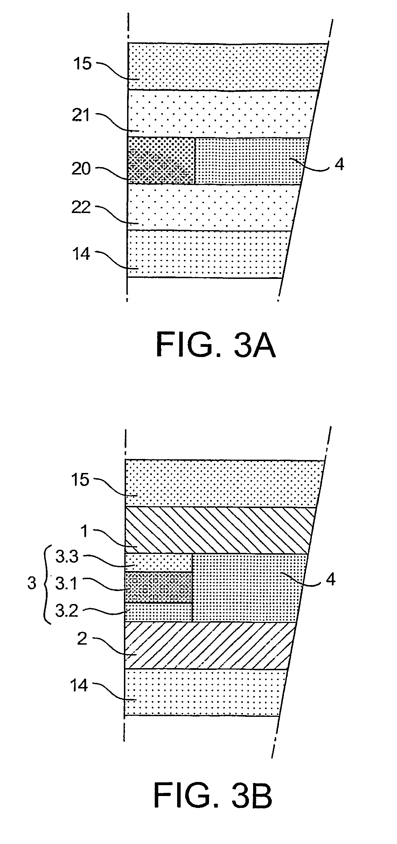

Les figures 3A, 3B représentent en coupe des modélisations, d'une part d'un élément de mémoire de l'art antérieur comportant entre deux contacts électriques 21, 22 une partie 20 en matériau mémoire à changement de phase monocouche, et d'autre part, d'un élément de mémoire selon l'invention comportant entre deux contacts électriques 1, 2, une partie 3 en matériau mémoire à changement de phase tricouche. Ces éléments mémoire sont portés par un substrat 14 par exemple en silicium et sont protégés à leur sommet par une couche de protection 15 par exemple en nitrure de silicium. Les parties en matériau mémoire à changement de phase sont confinées latéralement par de l'isolant comme décrit précédemment. Pour une même puissance électrique dissipée dans la partie en matériau mémoire à changement de phase, sur la figure 3A seule une partie en chapeau de champignon de ladite zone a fondu (partie grisée), sur la figure 3B toute la zone centrale active a fondu. La partie fondue est aussi grisée.

On choisira de préférence pour réaliser chaque zone extrême passive, un matériau ayant une conductivité thermique faible. Elle sera inférieure ou égale à celle du matériau du contact électrique qui lui est le plus proche. Il est aussi préférable que cette conductivité thermique soit inférieure ou égale à celle du matériau de la zone centrale active. Le matériau de chaque zone extrême passive agit comme une barrière thermique entre le matériau de la zone centrale active et le contact électrique avoisinant. Le brevet US-5 933 365 et le brevet US-4 177 475 précédemment cités évoquent de telles barrières thermiques.

En plus de leur rôle thermique, ces barrières sont des barrières de diffusion entre la zone centrale active et les contacts électriques, elles permettent d'éviter des migrations d'éléments vers les contacts électriques.

Ainsi à puissance égale, la température atteinte dans l'empilement sera plus élevée que dans le cas où cette condition sur la conductivité thermique n'est pas remplie. Il en résulte qu'il faut moins de puissance pour fondre la totalité du matériau de la zone centrale active et donc la sensibilité de l'élément de mémoire à l'impulsion d'écriture est améliorée et la consommation en énergie de l'élément de mémoire est réduite. Cette configuration a aussi pour avantage de rendre la sensibilité de l'élément de mémoire sensiblement constante au cours du temps.

Chaque zone extrême passive aura de préférence une résistance électrique inférieure ou égale à celle de la zone centrale active lorsqu'elle est dans son état le plus conducteur, c'est à dire dans son état cristallin. La présence des zones extrêmes passives n'affectera pas le contraste de résistivité. Ces zones extrêmes passives restent en totalité ou en quasi totalité cristallines lors d'une opération d'écriture de l'élément de mémoire. Ainsi il n'y aura pas de dégradation du signal de lecture au fur et à mesure des cycles d'écriture.

Pour accélérer la vitesse d'écriture de l'élément de mémoire, il est avantageux que le matériau de chaque zone extrême passive favorise la nucléation hétérogène de germes dans le matériau de la zone centrale active lorsqu'il est dans un état amorphe et donc accélère sa vitesse de cristallisation lors d'une transition de l'état amorphe à l'état cristallin. Ainsi le taux de nucléation hétérogène à l'interface est supérieur au taux de nucléation homogène dans le matériau de la zone centrale active. Cette condition est remplie lorsque le matériau de chaque zone extrême passive est de même nature que celle du matériau de la zone centrale active mais de composition différente.

Dans le cas où le matériau de chaque zone extrême passive est de nature différente de celui de la zone centrale active, ce phénomène peut se produire également dans certains cas, notamment lorsque le matériau des zones extrêmes passives est du GeN et le matériau de la zone centrale active du GeSbTe. On peut se référer aux explications données dans le document suivant : « Amorphisation and crystallisation mechanisms in GeSbTe-based phase change optical discs », B. Hyot et al., Journal of Magnetics Society of Japan, vol 25, n°3-2,2001, pages 414-419.

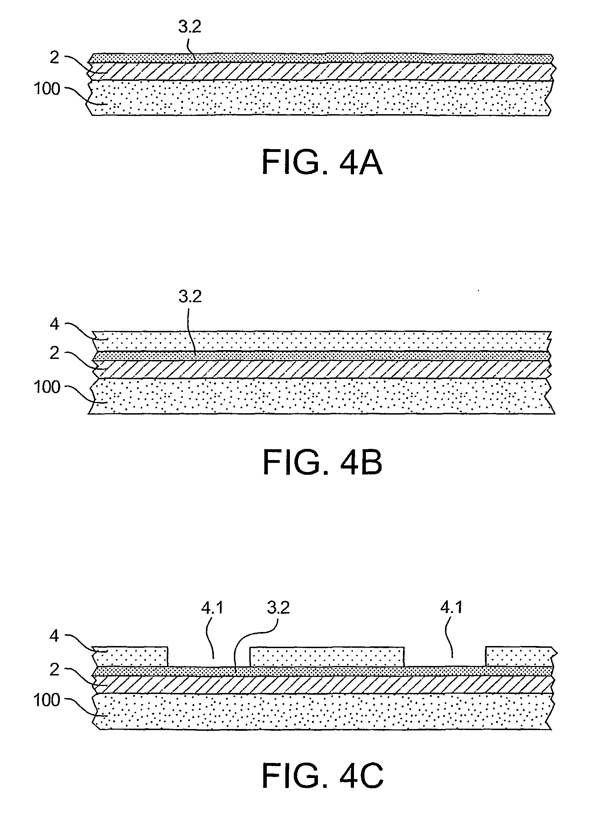

On va maintenant décrire un exemple de procédé de fabrication d'au moins un élément de mémoire à changement de phase selon l'invention. On part d'un substrat 100 de nature appropriée par exemple en silicium. On réalise au-dessus un premier contact électrique 2 par exemple à base d'or, d'argent, d'aluminium, de cuivre par un procédé de dépôt par pulvérisation cathodique (figure 4A). Ce contact électrique 2 est destiné à être relié électriquement à un dispositif d'adressage (non représenté) lui-même relié à un autre dispositif qui va délivrer notamment des impulsions pour l'écriture de l'élément de mémoire.

On recouvre ce premier contact électrique 2 d'une couche 3.2 de matériau mémoire à changement de phase (chalcogénure). Cette couche va former la première zone extrême passive. Ce dépôt peut se faire par exemple par pulvérisation cathodique.

On réalise au-dessus de la première zone extrême passive 3.2 une couche électriquement isolante 4 par exemple en oxyde ou en nitrure de silicium. Cette couche électriquement isolante peut être réalisée par exemple par PECVD (Plasma Enhanced Chemical Vapor Deposition soit dépôt chimique en phase vapeur assisté par plasma) (figure 4B).

On réalise ensuite un puits 4.1 pour chaque élément de mémoire dans la couche électriquement isolante 4. Le fond de chaque puits s'arrête sur la couche de la première zone extrême passive 3.2. La réalisation de ce puits 4.1 peut se faire par gravure RIE (reactive ion etching soit gravure ionique réactive) (figure 4C). C'est dans ce puits 4.1 que va prendre place la zone centrale active 3.1. Le puits 4.1 permet de confiner au moins partiellement latéralement la zone centrale active 3.1.

On dépose dans chaque puits 4.1 une couche de chalcogénure servant de zone centrale active 3.1. Elle peut déborder autour du puits 4.1. On la recouvre d'une autre couche de chalcogénure servant de seconde zone extrême passive 3.3. Ces dépôts, par exemple de compositions similaires à celles citées dans le premier exemple, peuvent se faire par exemple par pulvérisation cathodique. On structure ensuite le contour de ces deux couches 3.1, 3.3 (figure 4D). Elles peuvent s'étendre latéralement au-delà des puits 4.1.

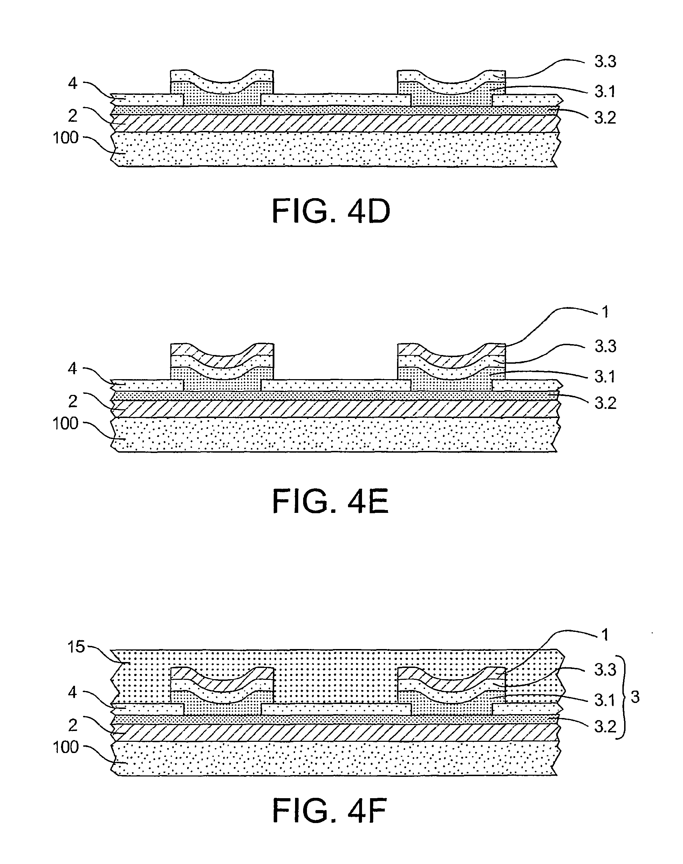

On réalise ensuite un second contact électrique 1 au-dessus de chaque puits 4.1 rempli (figure 4E). Sa réalisation peut être similaire à celle du premier contact électrique 2.

Une couche de protection 15 peut ensuite être déposée sur chaque second contact électrique 1 et autour. Une telle couche par exemple en nitrure de silicium peut être déposée par PECVD (figure 4F). Cette étape est facultative.

Un tel procédé de réaliser simultanément plusieurs éléments de mémoire sur le même substrat et donc une mémoire selon l'invention. Dans ces exemples les contacts électriques sont communs à plusieurs éléments mémoire réalisés sur le substrat 100, ils font partie de conducteurs électriques agencés en deux réseaux qui se croisent.

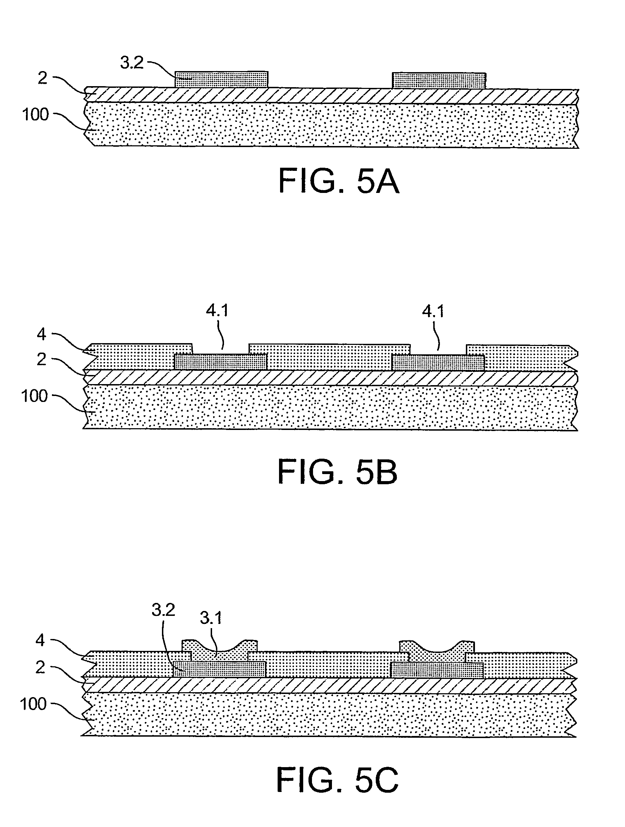

En variante, il est possible de structurer la couche conduisant à la première zone extrême passive de chacun des éléments de mémoire réalisés simultanément au lieu de la garder continue (figures 4). On se réfère aux figures 5A à 5F. On part d'un substrat 100 recouvert d'un premier contact électrique 2 similaire à celui représenté sur la figure 4A. On suppose que les procédés de dépôt et de gravure sont similaires à ceux cités précédemment.

On recouvre ce premier contact électrique 2 de matériau mémoire à changement de phase qui va former la première zone extrême passive 3.2 de chaque élément de mémoire. Le premier contact électrique est commun aux deux éléments qui vont être représentés sur ces figures. On grave le matériau mémoire pour délimiter le contour de chaque première zone extrême passive 3.2 (figure 5A).

On recouvre l'ensemble de matériau électriquement isolant 4. On grave dans le matériau électriquement isolant 4 un puits 4.1 au-dessus de chacune des premières zones extrêmes passives 3.2 (figure 5B) . Le fond des puits 4.1 atteint le matériau des premières zones extrêmes passives 3.2.

On dépose dans chacun de ces puits 4.1, le matériau mémoire des zones centrales actives 3.1 (figure 5C). Ce matériau peut dépasser latéralement au-delà des puits 4.1.

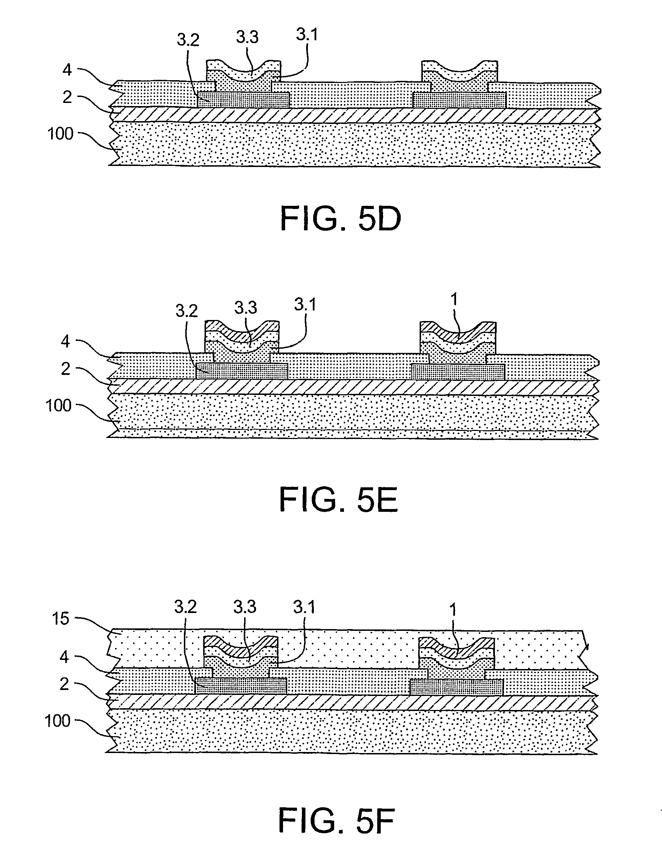

On réalise ensuite les secondes zones extrêmes passives 3.3 en déposant au dessus des puits 4.1 du matériau à changement de phase passif et en le gravant pour délimiter leur contour qui peut s'étendre latéralement au-delà des puits 4.1 (figure 5D).

On réalise ensuite les seconds contacts électriques 1, il y en a un au-dessus de chacune des secondes zones extrêmes passives 3.3. On effectue un dépôt conducteur et une étape de gravure pour délimiter leur contour (figure 5E).

On recouvre ensuite l'ensemble d'une couche de protection 15 (figure 5F). Cette étape est facultative.

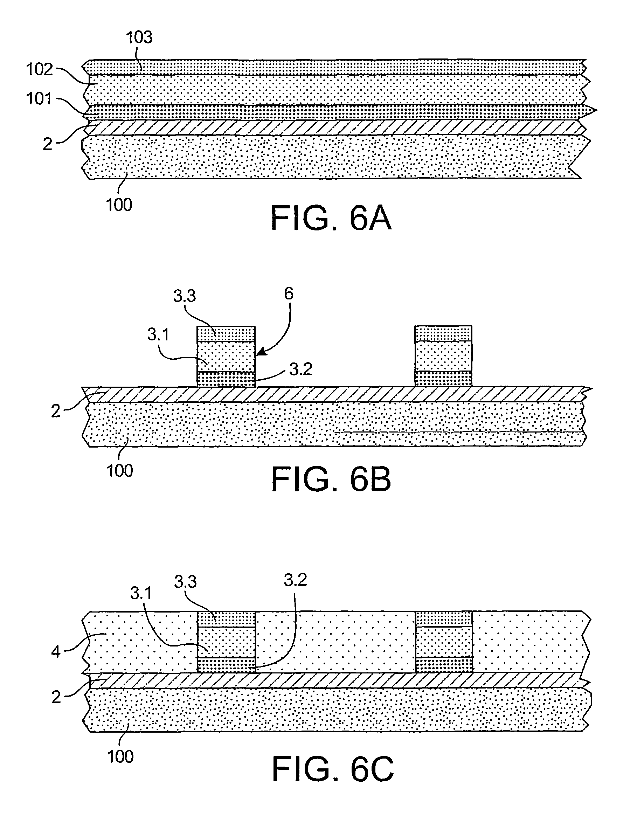

Encore une autre variante d'un procédé de réalisation d'au moins un élément de mémoire conforme à l'invention va être décrit en se référant aux figures 6A à 6C.

On part d'un substrat 100 recouvert d'un premier contact électrique 2 similaire à celui représenté sur la figure 4A.

On dépose successivement sur le premier contact électrique 2 un empilement de couches avec une première couche 101 conduisant pour chaque élément de mémoire à la première zone extrême passive, une seconde couche 102 conduisant à la zone centrale active, une troisième couche 103 conduisant à la seconde zone extrême passive (figure 6A). On va ensuite structurer cet empilement, en lui donnant la forme d'une colonne 6 (par élément de mémoire), de manière à faire apparaître l'empilement des zones extrêmes passives et de la zone centrale active (figure 6B). On peut réaliser une gravure par exemple de type IEB (ion beam etching soit gravure ionique).

On va ensuite enrober les colonnes 6 de matériau électriquement isolant 4. On peut déposer ce matériau par exemple par PECVD. Le matériau électriquement isolant 4 peut être par exemple de l'oxyde de silicium ou du nitrure de silicium. On planarise ensuite le matériau électriquement isolant 4 en mettant à nu les secondes zones extrêmes passives 3.3 (figure 6C).

On réalise ensuite les seconds contacts électriques 1. On peut procéder de la même manière qu'à l'étape illustrée à la figure 4E.

Il est ensuite possible, comme illustré à la figure 4F, de déposer une couche de protection 15 sur l'ensemble obtenu.

Une variante du procédé ainsi décrit peut consister au lieu de réaliser l'empilement sous forme de colonne de réaliser seulement la zone centrale active sous forme de colonne.

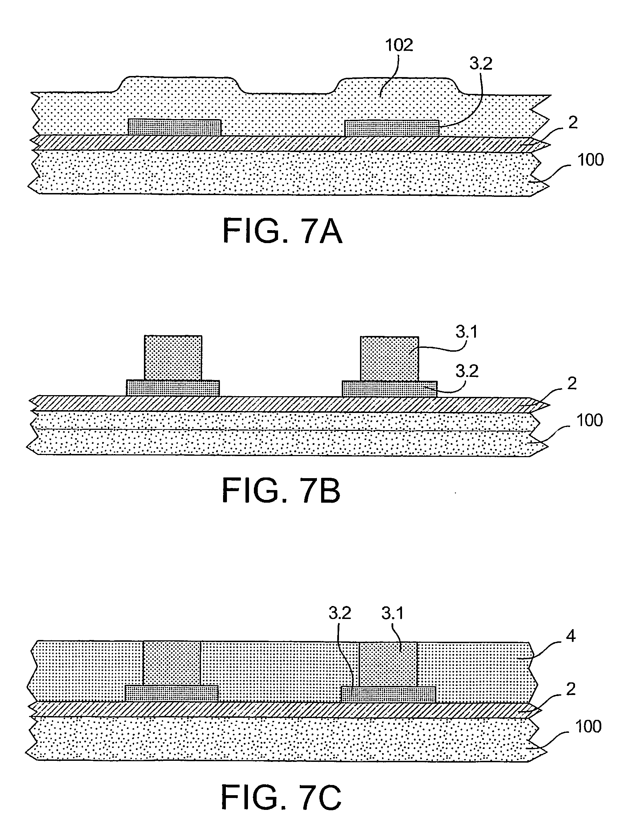

Cette variante est illustrée aux figures 7A à 7C.

On part d'une structure telle que celle illustrée à la figure 5A ou celle illustrée à la figure 4A avec les premiers contacts électriques 2 et les premières zones extrêmes passives 3.2. Pour ne pas multiplier les figures inutiles la suite du procédé se base sur la structure de la figure 5A.

On dépose au-dessus une couche 102 de matériau mémoire à changement de phase conduisant à la zone centrale active (figure 7A). On grave cette couche de manière à délimiter la zone centrale active 3.1 de chacun des éléments de mémoire (figure 7B).

On dépose ensuite une couche électriquement isolante 4 enrobant latéralement les premières zones extrêmes passives 3.2 et les zones centrales actives 3.1. On planarise cette couche électriquement isolante 4 de manière à mettre à nu le sommet des zones centrales actives 3.1 (figure 7C).

On procède ensuite comme expliqué à la figure 5D et suivantes.

Bien que plusieurs modes de réalisation de la présente invention aient été représentés et décrits de façon détaillée, on comprendra que différents changements et modifications puissent être apportés sans sortir du cadre de l'invention notamment en ce qui concerne les manières de procéder pour réaliser les étapes de dépôt et de gravure.

## Revendications

1. Elément de mémoire à changement de phase comportant entre deux contacts électriques (1, 2) une partie (3) en matériau mémoire à changement de phase amorphe-cristal et vice versa, en forme d'empilement avec une zone centrale (3.1) située entre deux zones extrêmes (3.2, 3.3), et comportant une interface (3.21, 3.31) entre la zone centrale dite active (3.1) et chaque zone extrême dite passive (3.2, 3.3), chaque zone extrême passive (3.2, 3.3) étant réalisée dans un matériau possédant une température de fusion supérieure à celle du matériau de la zone centrale active (3.1), **caractérisé en ce que** ladite interface (3.21, 3.31) est inerte ou quasi inerte d'un point de vue physico-chimique et que le matériau des zones extrêmes passives a une solubilité très faible voire nulle dans le matériau de la zone centrale active.

2. Elément de mémoire à changement de phase selon la revendication 1, **caractérisé en ce que** chaque zone extrême passive (3.2, 3.3) est réalisée dans un matériau possédant une conductivité thermique inférieure ou égale à celle du matériau du contact électrique (1, 2) qui lui est le plus proche et/ou à celle du matériau de la zone centrale active (3.1).

3. Elément de mémoire à changement de phase selon l'une des revendications 1 ou 2, **caractérisé en ce que** les zones extrêmes passives (3.2, 3.3) ont, dans une phase cristalline, une résistance électrique inférieure ou égale à celle de la zone centrale active (3.1) dans une phase cristalline.

4. Elément de mémoire à changement de phase selon l'une des revendications 1 à 3, **caractérisé en ce que** chaque zone extrême passive (3.2, 3.3) est réalisée dans un matériau favorisant un phénomène de formation de germes cristallins dans la zone centrale active (3.1) à proximité de l'interface (3.21, 3.31).

5. Elément de mémoire à changement de phase selon l'une des revendications 1 à 4, **caractérisé en ce que** chaque zone extrême passive (3.2, 3.3) est réalisée dans un matériau étant sensiblement de même nature chimique, mais de composition différente, que celles du matériau de la zone centrale active (3.1).

6. Elément de mémoire à changement de phase selon la revendication 5, **caractérisé en ce que** le matériau de la zone centrale active (3.1) comporte entre environ 16% et 30% de tellure et entre environ 84% et 70% d'antimoine, le matériau de chaque zone extrême passive (3.2, 3.3) étant de l'antimoine éventuellement mélangé à du tellure avec un pourcentage allant jusqu'à environ 2%, ces pourcentages étant des pourcentages atomiques.

7. Elément de mémoire à changement de phase selon l'une des revendications 1 à 4, **caractérisé en ce que** chaque zone extrême passive (3.2, 3.3) est réalisée dans un matériau qui est de nature chimique différente de celle du matériau de la zone centrale active (3.1).

8. Elément de mémoire à changement de phase selon la revendication 7, **caractérisé en ce que** le matériau de la zone centrale active (3.1) est du Ge2Sb2Te5 et le matériau de chaque zone extrême passive (3.2, 3.3) du GeN.

9. Elément de mémoire à changement de phase selon l'une des revendications 1 à 8, **caractérisé en ce que** les zones extrêmes passives (3.2, 3.3) sont réalisées dans un même matériau.

10. Elément de mémoire à changement de phase selon l'une des revendications 1 à 9, **caractérisé en ce que** la zone centrale active (3.1) est confinée au moins partiellement latéralement par du matériau électriquement isolant (4).

11. Elément de mémoire à changement de phase selon l'une des revendications 1 à 10, **caractérisé en ce qu'**au moins une des zones extrêmes passives (3.2, 3.3) déborde latéralement de la zone centrale active (3.1).

12. Elément de mémoire à changement de phase selon l'une des revendications 1 à 11, **caractérisé en ce qu'**au moins une des zones extrêmes passives (3.2, 3.3) et la zone centrale active (3.1) coïncident latéralement.

13. Elément de mémoire à changement de phase selon l'une des revendications 1 à 12, **caractérisé en ce qu'**au moins une des zones extrêmes passives (3.2, 3.3) est bordée par du matériau électriquement isolant (5, 4).

14. Mémoire **caractérisée en ce qu'**elle comporte une pluralité d'éléments de mémoire selon l'une des revendications 1 à 13.

15. Procédé de réalisation d'au moins un élément de mémoire à changement de phase comportant entre un premier et un second contacts électriques (1, 2) une partie (3) en matériau mémoire à changement de phase amorphe-cristal et vice versa, avec une zone centrale (3.1) située entre une première et une seconde zones extrêmes (3.2, 3.3), le procédé comportant les étapes suivantes :
a) réalisation du premier contact électrique (2) sur un substrat,
b) réalisation sur le premier contact électrique de la première zone extrême dite passive (3.2), de la zone centrale dite active (3.1) et de la seconde zone extrême dite passive (3.3), ces zones (3.1, 3.2, 3.3) formant un empilement (3) ayant une interface (3.21, 3.31) inerte ou quasi inerte d'un point de vue physico-chimique entre chaque zone extrême passive (3.2, 3.3) et la zone centrale active (3.1) qui est plus fusible que les zones extrêmes passives, le matériau des zones extrêmes passives ayant une solubilité très faible voire nulle dans le matériau de la zone centrale active,
c) réalisation d'un confinement latéral au moins partiel d'au moins la zone centrale active (3.1) avec un matériau électriquement isolant (4),
d) réalisation du second contact électrique (1) sur l'empilement (3).

16. Procédé selon la revendication 15, **caractérisé en ce que** le matériau électriquement isolant (4) confine latéralement également au moins une des zones extrêmes passives (3.2, 3.3).

17. Procédé selon la revendication 15, **caractérisé en ce que** les étapes b) et c) comprennent, après avoir réalisé la première zone extrême passive (3.2), les opérations suivantes :
- dépôt du matériau électriquement isolant (4) conduisant au confinement latéral, sur la première zone extrême passive (3.2),
- creusement d'un puits (4.1) dans le matériau électriquement isolant, ce puits ayant un fond atteignant la première zone extrême passive (3.2),
- remplissage du puits (4.1) avec une couche conduisant à la zone centrale active (3.1),
- réalisation de la seconde zone extrême passive (3.3) au-dessus du puits (4.1).

18. Procédé selon l'une des revendications 15 ou 16, **caractérisé en ce que** les étapes b) et c) comportent les opérations suivantes :
- dépôt sur le premier contact électrique (2) d'une première couche (101) conduisant à la première zone extrême passive (3.2),
- dépôt sur la première couche (101) d'une seconde couche (102) conduisant à la zone centrale active (3.1),
- dépôt sur la seconde couche (102) d'une troisième couche (103) conduisant à la seconde zone extrême passive (3.3),
- délimitation en colonne des trois couches déposées pour former l'empilement,
- enrobage latéral de l'empilement avec un matériau électriquement isolant (4) de confinement, ce matériau conduisant au confinement.

19. Procédé selon la revendication 15, **caractérisé en ce que** les étapes b) et c) comportent les opérations suivantes :
- dépôt sur la première zone extrême passive (3.2) d'une couche conduisant à la zone centrale active,
- délimitation de la zone centrale active (3.1),
enrobage latéral de la zone centrale active (3.1) avec un matériau électriquement isolant (4), ce matériau conduisant au confinement,
- réalisation de la seconde zone extrême passive (3.3) sur la zone centrale active (3.1).

## Claims

1. A phase-change memory cell including between two electrical contacts (1, 2), a portion (3) in a memory material with an amorphous-crystalline phase-change and vice versa, as a stack with a central area (3.1) located between two outmost areas (3.2, 3.3) and incorporating an interface (3.21, 3.31), between the so-called active central area (3.1) and each so-called passive outmost area (3.2, 3.3), each passive outmost area (3.2, 3.3) being made in a material having a melting temperature higher than that of the material of the active central area (3.1), **characterized in that** said interface (3.21, 3.31) is inert or quasi-inert from a physicochemical standpoint and that the material of the outmost passive areas have a very low or zero solubility in the material of the active central area.

2. The phase-change memory cell according to claim 1, **characterized in that** each passive outmost area (3.2, 3.3) is made in a material having a thermal conductivity less than or equal to that of the material of the electrical contact (1, 2) which is closest to it and/or to that of the material of the active central area (3.1).

3. The phase-change memory cell according to any of claims 1 or 2, **characterized in that** the passive outmost areas (3.2, 3.3) have in a crystalline phase, an electrical resistance less than or equal to that of the active central area (3.1) in a crystalline phase.

4. The phase-change memory cell according to any of claims 1 to 3, **characterized in that** each passive outmost area (3.2, 3.3) is made in a material promoting a phenomenon of formation of crystalline germs in the active central area (3.1) in proximity to the interface (3.21, 3.31).

5. The phase-change memory cell according to any of claims 1 to 4, **characterized in that** each passive outmost area (3.2, 3.3) is made in a material substantially of the same chemical nature but with a different composition, from those of the material of the active central area (3.1).

6. The phase-change memory cell according to claim 5, **characterized in that** the material of the active central area (3.1) includes between about 16% and 30% of tellurium and between about 84% and 70% of antimony, the material of each passive outmost area (3.2, 3.3) being antimony possibly mixed with tellerium with a percentage ranging up to about 2%, these percentages being atomic percentages.

7. The phase-change memory cell according to any of claims 1 to 4, **characterized in that** each passive outmost area (3.2, 3.3) is made in a material which is of a chemical nature different from that of the material of the active central area (3.1).

8. The phase-change memory cell according to claim 7, **characterized in that** the material of the active central area (3.1) is Ge2Sb2Te5 and the material of each passive outmost area (3.2, 3.3) is GeN.

9. The phase-change memory cell according to any of claims 1 to 8, **characterized in that** the passive outmost areas (3.2, 3.3) are made in a same material.

10. The phase-change memory cell according to any of claims 1 to 9, **characterized in that** the active central area (3.1) is at least partially confined laterally by electrically insulating material (4) .

11. The phase-change memory cell according to any of claims 1 to 10, **characterized in that** at least one of the passive outmost areas (3.2, 3.3) laterally overlaps the active central area (3.1).

12. The phase-change memory cell according to any of claims 1 to 11, **characterized in that** at least one of the passive outmost areas (3.2, 3.3) and the active central area (3.1) coincide laterally.

13. The phase-change memory cell according to any of claims 1 to 12, **characterized in that** at least one of the passive outmost areas (3.2, 3.3) is bordered with electrically insulating material (5, 4).

14. A memory, **characterized in that** it includes a plurality of memory cells according to claims 1 to 13.

15. A method for making at least one phase-change memory cell including between a first and second electrical contact (1, 2), a portion (3) in a memory material with amorphous-crystalline phase-change and vice versa, with a central area (3.1) located between first and second outmost areas (3.2, 3.3), the method including the following steps:
a) making the first electrical contact (2) on a substrate,
b) making on the first electrical contact, the first so-called passive outmost area (3.2), the so-called active central area (3.1) and the second so-called passive outmost area (3.3), these areas (3.1, 3.2, 3.3) forming a stack (3) with an interface (3.21, 3.31), inert or quasi-inert from a physico-chemical point of view, between each passive outmost area (3.2, 3.3) and the active central area (3.1) which is more meltable than the passive outmost areas,
c) achieving at least partial lateral confinement of at least the active central area (3.1) with an electrically insulating material (4),
d) making the second electrical contact (1) on the stack (3).

16. The method according to claim 15, **characterized in that** the electrically insulating material (4) laterally also confines at least one of the passive outmost areas (3.2, 3.3).

17. The method according to claim 15, **characterized in that** the steps b) and c) comprise, after having made the first passive outmost area (3.2), the following operations:
- depositing the electrically insulating material (4) leading to the lateral confinement, on the first passive outmost area (3.2),
- excavating a well (4.1) in the electrically insulating material, this well having a bottom reaching the first passive outmost area (3.2),
- filling the well (4.1) with a layer leading to the active central area (3.1),
- making the second passive outmost area (3.3) above the well (4.1).

18. The method according to any of claims 15 or 16, **characterized in that** the steps b) and c) include the following operations:
- depositing on the first electrical contact (2), a first layer (101) leading to the first passive outmost layer (3.2),
- depositing on the first layer (101), a second layer (102) leading to the active central area (3.1),
- depositing on the second layer (102), a third layer (103) leading to the second passive outmost layer (3.3),
- delimiting as a column, the three deposited layers to form the stack,
- laterally coating the stack with an electrically insulating confinement material (4), this material leading to confinement.

19. The method according to claim 15, **characterized in that** the steps b) and c) include the following operations:
- depositing on the first passive outmost layer (3.2), a layer leading to the active central area,
- delimiting the active central area (3.1),
- laterally coating the active central area (3.1) with an electrically insulating material (4), this material leading to confinement,
- making the second passive outmost area (3.3) on the active central area (3.1).

## Patentansprüche

1. Phasenänderungs-Speicherelement, zwischen zwei elektrischen Kontakten (1, 2) einen Teil (3) aus Speichermaterial mit amorph-kristalliner und umgekehrter Phasenänderung in Stapelform mit einer Mittelzone (3.1) zwischen zwei Außenzonen (3.2, 3.3) umfassend, und eine Grenzfläche (3.21, 3.31) zwischen der aktiv genannten Mittelzone (3.1) und jeder passiv genannten Außenzone (3.2, 3.3) umfassend, wobei jede passive Außenzone (3.2, 3.3) aus einem Material ist, dessen Schmelztemperatur höher ist als die des Materials der aktiven Mittelzone (3.1),
**dadurch gekennzeichnet, dass** die genannte Grenzfläche (3.21, 3.31) in physikalisch-chemischer Hinsicht inert oder quasi inert ist, wobei die Löslichkeit des Materials der passiven Außenzonen in dem Material der aktiven Mittelzone sehr gering, ja sogar null ist.

2. Phasenänderungs-Speicherelement nach Anspruch 1, **dadurch gekennzeichnet, dass** jede passive Außenzone (3.2, 3.3) aus einem Material mit einer Wärmeleitfähigkeit niedriger oder gleich der des Materials des ihr nächsten elektrischen Kontakts (1, 2) und/oder der des Materials der aktiven Mittelzone (3.1) ist.

3. Phasenänderungs-Speicherelement nach einem der Ansprüche 1 oder 2, **dadurch gekennzeichnet, dass** die passiven Außenzonen (3.2, 3.3) in einer kristallinen Phase einen elektrischen Widerstand kleiner oder gleich dem der aktiven Mittelzone (3.1) in einer kristallinen Phase haben.

4. Phasenänderungs-Speicherelement nach einem der Ansprüche 1 bis 3, **dadurch gekennzeichnet, dass** jede passive Außenzone (3.2, 3.3) aus einem Material ist, das ein Kristallkeimbildungsphänomen in der aktiven Mittelzone (3.1) in der Nähe der Grenzfläche (3.21, 3.31) begünstigt.

5. Phasenänderungs-Speicherelement nach einem der Ansprüche 1 bis 4, **dadurch gekennzeichnet, dass** jede passive Außenzone (3.2, 3.3) aus einem Material von im Wesentlichen derselben chemischen Art aber von anderer Zusammensetzung als derjenigen der aktiven Mittelzone (3.1) ist.

6. Phasenänderungs-Speicherelement nach Anspruch 5, **dadurch gekennzeichnet, dass** das Material der aktiven Mittelzone (3.1) zwischen ungefähr 16% und 30% Tellur und zwischen 84% und 70% Antimon enthält, wobei das Material jeder passiven Außenzone (3.2, 3.3) Antimon ist, eventuell mit Tellur mit einem Prozentsatz von bis zu ungefähr 2% gemischt, wobei diese Prozentsätze Atomprozentsätze sind.

7. Phasenänderungs-Speicherelement nach einem der Ansprüche 1 bis 4, **dadurch gekennzeichnet, dass** jede passive Außenzone (3.2, 3.3) aus einem Material von anderer chemischer Art als derjenigen der aktiven Mittelzone (3.1) ist.

8. Phasenänderungs-Speicherelement nach Anspruch 7, **dadurch gekennzeichnet, dass** das Material der aktiven Mittelzone (3.1) Ge2Sb2Te5 ist und das Material jeder passiven Außenzone (3.2, 3.3) GeN.

9. Phasenänderungs-Speicherelement nach einem der Ansprüche 1 bis 8, **dadurch gekennzeichnet, dass** die passiven Außenzonen (3.2, 3.3) aus einem selben Material sind.

10. Phasenänderungs-Speicherelement nach einem der Ansprüche 1 bis 9, **dadurch gekennzeichnet, dass** die aktive Mittelzone (3.1) lateral wenigstens partiell durch elektrisch isolierendes Material (4) eingeschlossen ist.

11. Phasenänderungs-Speicherelement nach einem der Ansprüche 1 bis 10, **dadurch gekennzeichnet, dass** wenigstens eine der passiven Außenzonen (3.2, 3.3) lateral über die aktive Mittelzone (3.1) hinausragt.

12. Phasenänderungs-Speicherelement nach einem der Ansprüche 1 bis 11, **dadurch gekennzeichnet, dass** wenigstens eine der passiven Außenzonen (3.2, 3.3) und die aktive Mittelzone (3.1) lateral übereinstimmen.

13. Phasenänderungs-Speicherelement nach einem der Ansprüche 1 bis 12, **dadurch gekennzeichnet, dass** wenigstens eine der passiven Außenzonen (3.2, 3.3) durch elektrisch isolierendes Material (5, 4) begrenzt wird.

14. Speicher, **dadurch gekennzeichnet, dass** er eine Vielzahl von Speicherelementen nach einem der Ansprüche 1 bis 13 umfasst.

15. Verfahren zur Herstellung wenigstens eines Phasenänderungs-Speicherelements, das zwischen einem ersten und einem zweiten elektrischen Kontakt (1, 2) einen Teil (3) aus Speichermaterial mit amorph-kristalliner und umgekehrter Phasenänderung mit einer zwischen zwei Außenzonen (3.2, 3.3) befindlichen Mittelzone (3.1) umfasst, wobei das Verfahren die folgenden Schritte umfasst:
a) Realisierung des ersten elektrischen Kontakts (2) auf einem Substrat,
b) Realisierung - auf dem ersten elektrischen Kontakt - der ersten passiv genannten Außenzone (3.2), der aktiv genannten Mittelzone (3.1) und der zweiten passiv genannten Außenzone (3.3), wobei diese Zonen (3.1, 3.2, 3.3) einen Stapel (3) bilden, mit einer in physikalisch-chemischer Hinsicht inerten oder quasi inerten Grenzfläche (3.21, 3.31) zwischen jeder passiven Außenzone (3.2, 3.3) und der aktiven Mittelzone (3.1), die schmelzbarer bzw. leichter schmelzbar ist als die passiven Außenzonen, wobei die Löslichkeit des Materials der passiven Außenzonen in dem Material der aktiven Mittelzone sehr gering, ja sogar null ist,
c) Realisierung einer wenigstens partiellen lateralen Einschließung von wenigstens der aktiven Mittelzone (3.1) mit einem elektrisch isolierenden Material (4),
d) Realisierung des zweiten elektrischen Kontakts (1) auf dem Stapel (3).

16. Verfahren nach Anspruch 15, **dadurch gekennzeichnet, dass** das elektrisch isolierende Material (4) lateral auch wenigstens eine der passiven Außenzonen (3.2, 3.3) einschließt.

17. Verfahren nach Anspruch 15, **dadurch gekennzeichnet, dass** die Schritte b) und c) nach Realisierung der ersten passiven Außenzone (3.2) die folgenden Operationen umfassen:
- Abscheiden des elektrisch isolierenden Lateraleinschließungsmaterials (4) auf der ersten passiven Außenzone (3.2),
- Herstellen einer Vertiefung (4.1) in dem elektrisch isolierenden Material, wobei der Boden dieser Vertiefung die erste passive Außenzone (3.2) erreicht,
- Füllen der Vertiefung (4.1) mit einer zu der aktiven Mittelzone (3.1) führenden Schicht,
- Realisieren der zweiten passiven Außenzone (3.3) über der Vertiefung (4.1).

18. Verfahren nach einem der Ansprüche 15 oder 16, **dadurch gekennzeichnet, dass** die Schritte b) und c) die folgenden Operationen umfassen:
- Abscheiden einer zu der ersten passiven Außenzone (3.2) führenden Schicht (101) auf dem ersten elektrischen Kontakt (2),
- Abscheiden einer zu der aktiven Mittelzone (3.1) führenden zweiten Schicht (102) auf der ersten Schicht (101),
- Abscheiden einer zu der zweiten passiven Außenzone (3.3) führenden dritten Schicht (103) auf der zweiten Schicht (102),
- säulenförmiges Begrenzen der drei abgeschiedenen Schichten, um den Stapel auszubilden,
- laterales Umhüllen des Stapels mit einem elektrisch isolierenden Einschließungsmaterial (4), wobei dieses Material zu der Einschließung führt.

19. Verfahren nach Anspruch 15, **dadurch gekennzeichnet, dass** die Schritte b) und c) die folgenden Operationen umfassen:
- Abscheiden einer zu der aktiven Mittelzone führenden Schicht auf der ersten passiven Außenzone (3.2),
- Abgrenzen der aktiven Mittelzone (3.1),
- laterales Umhüllen der aktiven Mittelzone (3.1) mit einem elektrisch isolierenden Material (4), wobei dieses Material zu der Einschließung führt,
- Realisieren der zweiten passiven Außenzone (3.3) auf der aktiven Mittelzone (3.1).
